# EUROPEAN PATENT APPLICATION

(11) **EP 2 214 183 A1**
(43) Date of publication of application: **04.08.2010**
(21) Application number: 10386002.9
(22) Date of filing: 18.01.2010
(51) Int. Cl.: H01F 17/00

(54) **Integrated, printed margarita- or clover shaped inductor**

(30) Priority: 16.01.2009 GR 20090100028
(71) Applicant: Aristotle University Thessaloniki, Research Committee, 54124 Thessaloniki (GR); Chatzopoulos, Alikiviades, 55132 Thessaloniki (GR); Bontzios, Giorgos, 54352 Thessaloniki (GR)
(72) Inventor: Chatzopoulos, Alikiviades, 55132 Thessaloniki (GR); Bontzios, Giorgos, 54352 Thessaloniki (GR)
(74) Representative: Petsis, Christos

(57) **Abstract**

The invention relates to an inductor, notably of the integrated or printed type, comprising a plurality of open loops with a predetermined shape connected in series along a virtual path around a geometrical centre, each loop having two ends with their respective open side located between both said ends, thereby facing said fictive centre, remarkable in that said open loops are mutually connected at their said ends belonging to two adjacent loops, thereby facing said centre, wherein each said loop is mutually rotated over an angle respective the adjacent loop around geometrical centre, more particularly wherein it has a margarita shape comprising a set of petals as open loops, wherein said petals are connected in series along a virtual path to form the inductor turns, wherein each petal is turned to an angle to each preceding petal and the open part of the petals faces the centre of the inductor. The invention also relates to a manufacturing method of said inductor and its use.

## Description

### Field of the invention

The present invention relates to the field of semiconductor devices and more specifically to an integrated inductor structure and its method of fabrication.

### Background of the invention

Integrated inductors are widely used in microelectronics and particularly in RF integrated circuits (Radio Frequency Integrated Circuits - RFICs) and in microwave monolithic integrated circuits (MMICs). Integrated inductors are known as key devices in low noise amplifiers (LNAs). LNA is a special type of electronic amplifier used in communication systems to amplify very weak signals received by an antenna. They are also widely used in microwave systems such as GPS standing for General Positioning System, due to low losses in the microwave frequency range. Typically, one or more integrated inductor devices are used to fabricate it. The operating frequency of an LNA is an important design specification and is influenced by its elements. For this reason, the inductors used in the LNAs need to be featured by a high quality factor Q, for the required inductance values L. The quality factor Q is the parameter of the inductor which characterizes its performance and is defined as the ratio of the energy of the magnetic field that can be stored in the inductor to the electric energy losses during its operation. Using the inductor parameters, the quality factor is defined as Q=Lω/R, where L and R is the total inductance and resistance of the inductor and w is the frequency at which it is measured.

Furthermore, due to the constant demand for higher frequencies of operation regarding the electronic circuits, there is a struggle to find ways to increase the bandwidth of operation of the integrated inductors. Two are the main frequency ranges of interest in the design process. Firstly, the resonance frequency, where the inductor loses its inductive properties, and secondly, the frequency of the highest quality factor value.

Another type of inductors widely used in microelectronics is the category of printed inductors which are fabricated or printed on PCBs (Printed Circuit Boards). The material which they are fabricated on is usually silicon based. Other materials such as fabric may also be used. The difference between the two types of inductors merely lies in the fabrication process. The printed inductor is fabricated on any printed circuit board (PCB), while the integrated one on an integrated chip following the rules imposed by the specific process at each case. This results in that the shape of the inductor and the design steps are in both cases the same.

Up to now, the design of integrated inductors mainly consists of connecting in series two or more inductors of single or multi-turn which are designed in the different metal layers provided by each technology. Each layer consists of a continuous spiral metal track forming the inductor turns. Different metal layers are isolated from each other by oxide layers between them. The series combination of inductors is achieved by so-called vias provided by each technology, which are vertical metal lines connecting two adjacent metal layers. The two free ends of the continuous track, formed by the inductors connected in series, are the ports of the entire inductor. The inductor design almost always starts from the top metal layer, since most of the technologies provide a special metal for this purpose, while by this way a better isolation from the substrate is achieved. In the specific case of a one layer and 2,5 turn inductor, designed at one layer, a metal track at a different layer is used, to connect the port inside the inductor, with a point outside of it. The connection of the metal line with the two connecting points is achieved by use of vias. Such a line which connects two coplanar points in general, but resides in a different - usually the lower next - layer is called underpass. Two points are connected with underpass when the direct (coplanar) connection would short circuit other points in the chip.

The main design parameters of integrated inductors comprise the outer diameter of the inductor, the width of metal tack lines and the distance between them, and the number of turns and layers.

Several methods have been reported to increase either the quality factor or the main operating frequency values of interest regarding inductors. Most of them rely on either of unconventional materials such as substrates GaAS, or the post-processing of the chip such as etching, after its fabrication introducing additional steps in the production of the chip, possibly resulting in dramatically increasing the fabrication cost.

Other methods are based on exotic technologies, such as MEMS, increasing even more the cost of the final product.

Finally, still other methods based on the existing conventional technology, such as patterned ground Shields, do not provide significant improvement due to parasitic effects such as so-called eddy currents.

For this reason there is a need to increase the quality factor and the basic operating frequency values of integrated inductors by using conventional low cost technology without introducing additional steps that would lead to an increased cost of the final chip.

### Prior art

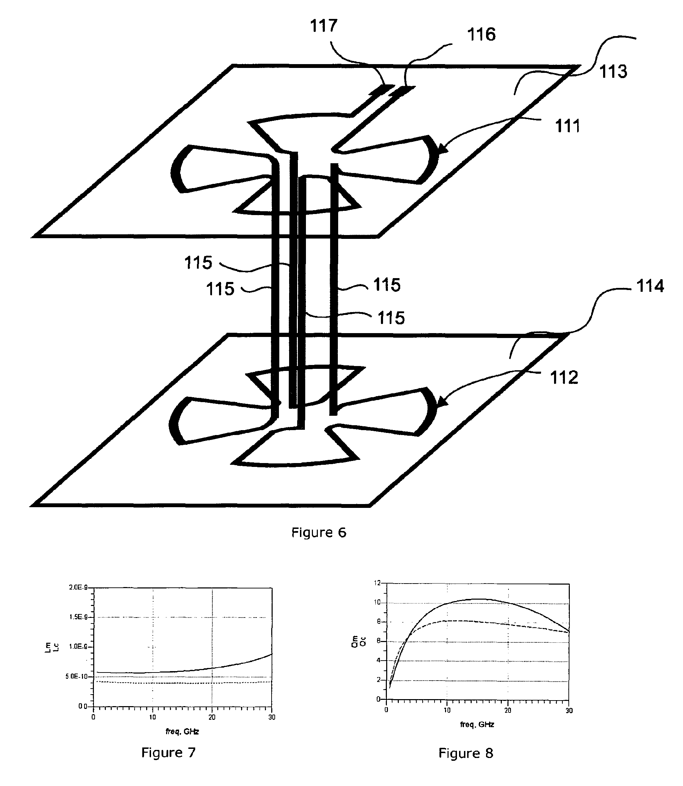

The patent US6175727 is referring to a suspended printed inductor (SPI) and an LC-type printed filter using the said SPI. It mentions only printed components on PCBs, not about integrated inductors, and the application is restricted to frequencies up to tenths of MHz, as it can be seen from the figs. 7, 8, 9. There is no relation to the GHz range of applications and not at all reference of a shape for the inductor.

EP1304707 A3 refers to a method of making multiple layer inductors. It mentions only printed components on PCBs, not about integrated inductors, and the application is restricted to PCB as it can be deducted from the formula provided for the calculation of inductance L. There is no relation to the GHz range of applications and not at all reference of a shape for the inductor.

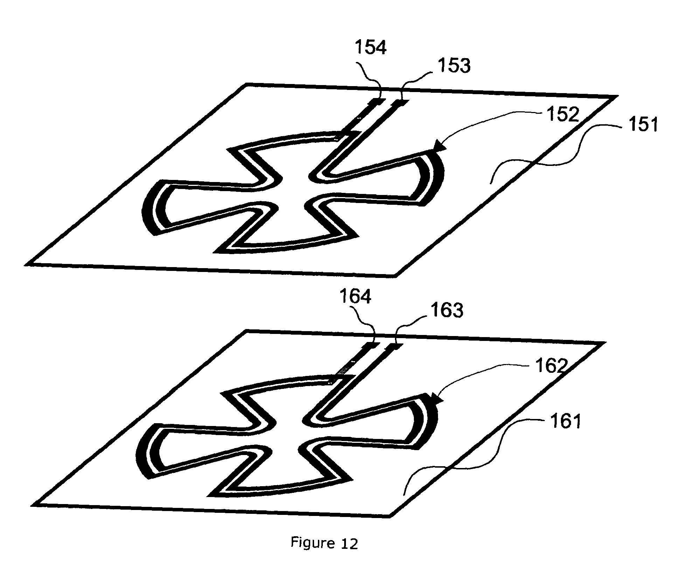

US7147604 B1 refers to a sensor for wirelessly determining a physical property within a defined space. The said sensor is fabricated using MEM system technology and is deployed on flexible material in order to be easily entered to human body. The shape of fig. 12 is elaborated only to lend more complex folding patterns that could facilitate delivery to specific anatomical location within an artery and has nothing to do with our technical perspective for the performance of an integrated inductor. The said shape is referred to only as a capacitor surface and nothing is mentioned on its inductive performance.

It is to be stated however that the performance of the planar integrated inductors has reached a limiting point. The most commonly used shape of integrated inductors is the octagonal which has been shown to exhibit both good overall performance and availability in all of the fabrication technologies. It is thus apparent that novel design shapes are necessary if we want to push the performance of the integrated inductors to higher level.

### Object of the invention

It is an object of the invention to provide a solution to the afore-mentioned problems by introducing a new design shape using conventional low-cost technology and without the need for additional steps in the fabrication process apart from the standard ones.

The main object of the invention is thus to propose a totally innovative shape that is such that secondary mutual coupling effects occurring wherein contribute to the increase of the overall inductance value. The fundament consists in having small current loops arranged as petals, corresponding to inductance value L0, connected in series for the inductance value to add up to a higher value. The loops are connected along a circular path, which offers the substantial advantage to minimize the total chip area occupied, and even more remarkable to form a secondary loop in the center of the inductor resulting to a stronger magnetic flux and therefore to a higher inductance value, which is due to both self inductance of the secondary loop and to the mutual inductance of it with the petals.

### Summary of the invention

There is thus proposed according to the invention an integrated respectively printed shaped inductor as defined in the main claim 1 hereinafter, consisting of a set open loops, the petals, which are connected together in series forming its turns, thereby comprising a plurality of open loops with a predetermined shape connected in series along a virtual path around a virtual geometrical centre, each loop having two ends with their respective open side located between both said ends, thereby facing said fictive centre, wherein said inductor is remarkable in that its open loops are mutually connected at their said ends belonging to two adjacent loops, thereby facing said centre, wherein each said loop is mutually rotated over an angle respective the adjacent loop around geometrical centre.

Its advantage compared to conventional integrated inductors is that, for a given value of inductance, a higher quality factor at an even higher frequency value is provided while equal surface area is occupied on the chip. A direct consequence is that, with the same fabrication cost and equal occupied area, higher quality factor values at higher frequency can be achieved. In fact, as the proposed invention is consistent with all the conventional design rules, it can be fully integrated into all conventional technologies regarding fabrication of integrated inductors.

According to a preferred embodiment of the invention, said integrated or printed inductor has a margarita shape comprising open loops, a set of petals, wherein the petals are connected in series along a virtual path to form the inductor turns and each petal is turned to an angle to each preceding petal and the open part of the petals faces the centre of the inductor.

Additionally, all the traditional methods for increasing the quality factor or the frequency of operation can be also applied, if desired, for further improving the parameters of the invention.

In other words, a technical effect is generated by the so-called margarita shape which consists in that said shape gives a higher inductance and quality factor than a square shape.

According to a further preferred embodiment of the invention, the number of petals is equal or greater than two, in particular equal or smaller than 4, more particularly wherein all said loops have a virtually identical shape. The abovementioned best embodiment with maximum 4 loops is suitably represented by a clover shape wherein the aforementioned petals of the shape proposed according to the invention actually form the leaves of said clover like shape. In other words, the shape as proposed according to the invention may equally be designated by a clover like shape in the embodiment with maximum 4 loops, including 3, which constitutes an alternative representation of the inductor specifically shaped according to the invention.

According to a still further preferred embodiment of the invention, said open loops in said margarita like shape delimitate the margarita petals' perimeter, in particular composed of at least three parts, a peripheral one extending outwardly and two adjacent parts extending radially therefrom to said virtual centre.

According to a yet further preferred embodiment of the invention, each said open loop has a substantially curved like shape pointing at said virtual centre, in particular with an elongated profile, at least slightly, wherein said junction portions have an inwardly curved profile facing said centre. Alternatively, each curve is replaced by a combination of straight line segments so as to approximate the curve, in particular with maximum angles and smallest number of straight line segments.

According to a further embodiment of the invention, it has a generally symmetrical overall shape with respect to said centre and/or in that said loops are arranged substantially in a plane.

Moreover, the proposed invention can be combined with the traditional inductors if required, in particular as a connection in series, connection in parallel or combination of them.

According to an alternative embodiment according to the invention, the margarita-shaped inductor according to this invention may consist of one or more turns and one or more layers, in particular wherein two consecutive layers are connected together using vias.

In a further embodiment of the margarita-shaped inductor according to this invention, the open part of each petal faces the center of the inductor.

In a still further embodiment of the invention, each petal is turned to an angle in respect with any precedent and the petals are connected along a virtual closed curve, which defines the turn of the inductor.

In a yet further embodiment of the invention, petals are connected together by circular segments. Any other curved or even straight path may be used for their connection.

The present invention further relates to a method for manufacturing an integrated or printed margarita shaped inductor wherein the integrated or printed margarita shaped inductor is fabricated in any method, respectively wherein the integrated or printed margarita shaped inductor is fabricated to any metal layer and any type of metal offered by the process.

The proposed shape can thus be fabricated in any fabrication process with no special fabrication steps required in any metal layer available by the said process.

A margarita-shaped inductor according to this invention is fabricated in the same way as the traditional inductors, that is, by a continuous metal track. Advantageously the top metal is used for the reasons mentioned earlier regarding the traditional inductors. The width of the metal track can be constant or variable and, as with the total length, may have any value.

The proposed shape can thus be fabricated in any fabrication process with no special fabrication steps required in any metal layer available by the said process.

Finally, the present invention also relates to the use of the inductor as defined above, wherein said inductor is incorporated in a complete circuit such as an LNA or a GPS receiver or a transceiver. Thanks to the incorporation of said clover shaped inductor in the whole circuit, the performance of said complete circuit like an LNA or a GPS receiver or a transceiver is generally improved.

The accompanying drawings are included to provide a further understanding of the invention, and are incorporated in and constitute a part of this specification. The drawings illustrate embodiments of the invention and, together with the description, serve to explain the principles of the invention.

### Brief description of the drawings

Figure 1 shows a three dimensional drawing of a classic square inductor of 2,5 turns and 2 layers.
Figure 2 is a cross-section of Figure 1.
Figure 3 illustrates an known example of using underpass to a single layer square inductor of 2,5 turns.
Figure 4 is a plan view of a single layer 2-turn margarita-shaped inductor, according to the invention.
Figure 5 depicts a three dimensional plan of a two-layer two-turn margarita-shaped inductor according to the invention, showing the use of vias.
Figure 6 shows a two-layer one-turn margarita-shaped inductor according to the invention, in alternative connection.
In Figures 7 and 8, a comparison of inductance L and the quality factor Q as a function of frequency of operation is depicted, between a traditional single-layer single-turn spiral inductor and a single-layer single-turn margarita-shaped inductor according to the invention.
In Figures 9 and 10 a comparison of inductance L and the quality factor Q as a function of frequency of operation is depicted, between a traditional two-layer single-turn spiral inductor and a two-layer single-turn margarita-shaped inductor with alternative design according to the invention.
Figure 11 shows a single-layer two-turn margarita-shaped inductor according to the invention, combined with a traditional square inductor of single layer and 2,5 turns.
Figure 12 illustrates two single-layer margarita-shaped inductors of two turns, according to the invention, connected as a transformer in two different layers.
Figure 13 illustrates two single-layer single-turn margarita-shaped inductors, according to the invention, connected as a transformer in the same layer.
Figures 14a and 14b regard the design of the inductor shaped according to the invention in practice and the comparison between measurement results of a margarita, respectively clover and a typical octagonal inductor respectively.
Figure 15 shows a comparison between a margarita, respectively clover shape inductor of two petals and a typical octagonal one of 0,5 turn in a layout of the test chip fabricated.

### Description

The device described hereafter will be, for the sake of simplicity, considering the design of integrated inductors only. Since designing printed inductors is similar to that of integrated ones, with the latter to be more complex as more steps and parameters are introduced during the fabrication process, their design on PCBs directly emerges from their design in integrated circuits.

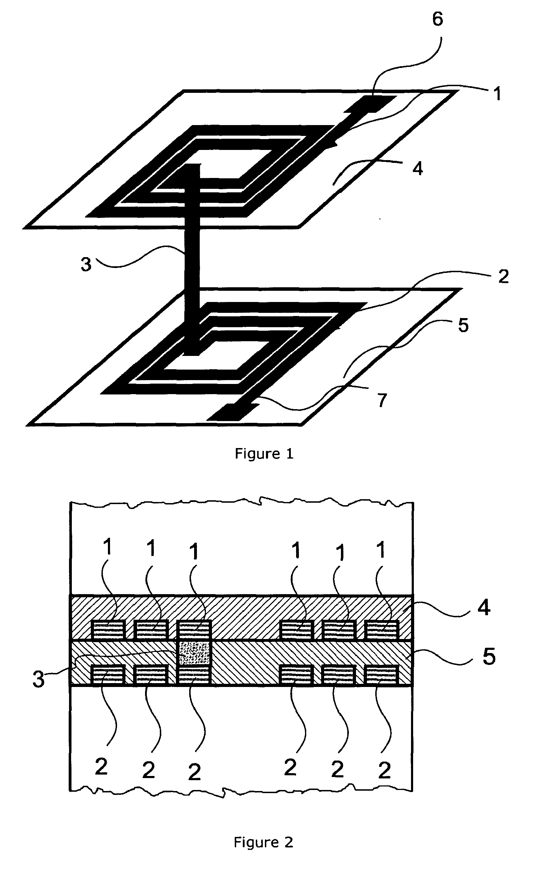

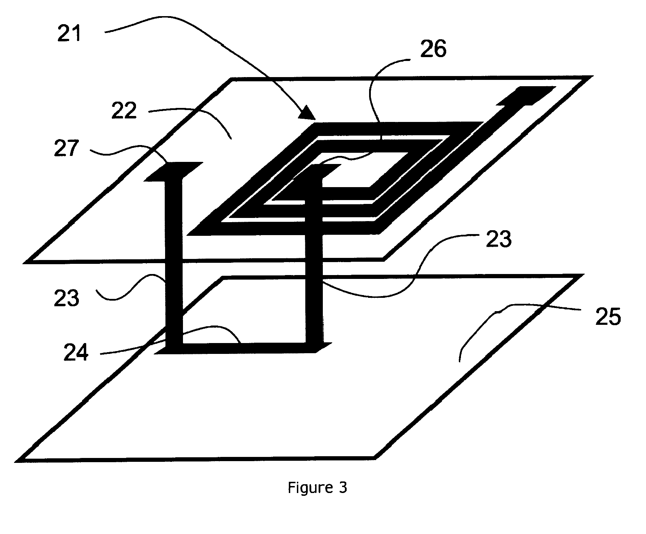

The design of integrated inductors up to now mainly consists of connecting in series two or more inductors of single or multi-turn which are designed in the different metal layers provided by each technology, as shown in Figure 1, where a square inductor of 2,5 turns and two layers is depicted. Figure 2 illustrates the cross-section of Figure 1 maintaining the same numbering for ease of reading. Each layer consists of a continuous spiral metal track 1, 2 forming the inductor turns. Different metal layers are isolated from each other by oxide layers 4, 5 between them. As shown in Figure 1, the series combination of inductors is achieved by the so-called vias 3 provided by each technology. Vias are vertical metal lines connecting two adjacent metal layers. The two free ends 6, 7 of the continuous track, formed by the inductors connected in series, are the ports of the entire inductor. The inductor design almost always starts from the top metal layer, since most of the technologies provide a special metal for this purpose, while by this way a better isolation from the substrate is achieved. Figure 3 shows the specific case of a one layer and 2,5 turn inductor 21, designed at one layer 22, where a metal track 24 at a different layer 25 is used, to connect the port 26 inside the inductor, with a point 27 outside of it. The connection of the metal line with the two connecting points is achieved by use of vias 23. Such a line which connects two coplanar points in general, but resides in a different - usually the lower next - layer is called underpass. Two points are connected with underpass when the direct (coplanar) connection would short circuit other points in the chip.

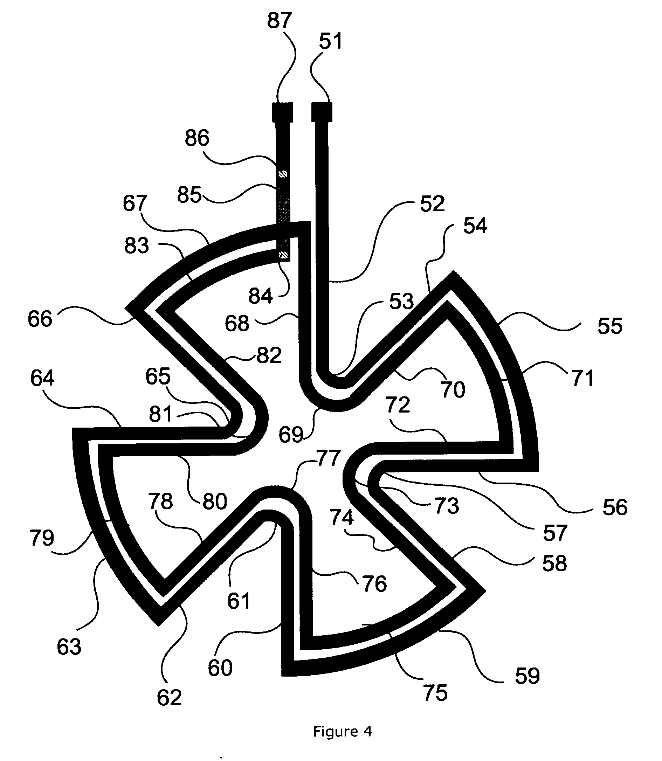

As shown in Figure 4, the outer turn, also called as the primary or the first, consists of the continuous track 52 - 68, while the inner, or second, turn, consists of the continuous track 69 - 83. The petals of the first turn comprise the continuous tracks 54 - 55 - 56, 58 - 59 - 60, 62 - 63 - 64 and 66 - 67 - 68, connected consecutively through the segments, 57, 61 and 65 respectively. The petals of the second turn comprise the continuous tracks 70 - 71 - 72, 74 - 75 - 76, 78 - 79 - 80, 82 - 83, connected through the segments 73, 77 and 81 respectively. The connection between the two turns is achieved by segment 69. The margarita-shaped inductor according to this invention has two ports 51 and 87 just as the traditional inductors. Port 87 is connected with the second turn through underpass 85 which is connected with the second turn and the connector using vias 84 and 86 respectively.

Advantageously, all the petals are substantially identical for maximum performance. However, both the total length and the shape of each petal may be different from the other ones.

Each turn encloses every inner turn and each petal encloses every inner petal respectively. A deviation from the above is possible but in this case underpass is required, which unnecessarily increases the complexity of the design. Any number of continuous or non continuous petals, may be omitted, by connecting the corresponding petals located right before and right next of every group of consecutive petals omitted. If the connection is not possible on the same layer without short-circuiting other petals, it can be achieved in a different layer using underpass. For maximum overall performance, the choice for the petal shape must take into consideration the following conflicting design restrictions: each petal to be located as far as possible with each other, to enclose the largest possible area, to have the smallest total length and the total surface area occupied by the overall margarita-shaped inductor be the minimum one.

Thus, referring to Figure 4 and in particular to the petal 54 - 55 - 56, the best shape of the petal is composed by two equal line segments 54 and 56, the rays, forming an acute angle and a circular segment 55 connecting two opposite ends of theirs. One way to obtain this design is to draw two concentric circles and take the closed loop defined by two radii of the circles forming an acute angle, and the circular sectors cut by the radii, removing the sector cut by the inner circle.

The best shape is composed by two equal line segments 54, 56 forming an acute angle, and a circular segment 55. The effect produced by these features is as follows : the optimal shape for the petal is determined by complying with the following conflicting conditions. It must enclose the largest possible area - for the magnetic field to be stronger, on the one hand, it must have the minimum possible length and no acute angle should be formed, on the other hand and the overall surface are occupied by the margarita inductor should be minimum due to cost reasons.

Each turn may consist of any number of petals. Due to the restrictions described in previous section, for best results, the maximum number of petals for each turn should not exceed four. For this amount, two consecutive rays form an angle of substantially 45°.

An effect is produced by an interaction of two consecutive rays, because the current flows in two opposite directions. Indeed, due to the opposite directions of the current flow, the mutual coupling between those rays is negative, thus producing in effect a negative mutual inductance. For this reason the distance between these opposite rays should be as long as possible. However, the positive mutual coupling due to each petal outperforms the negative one resulting in a positive total inductance.

If the design of circular segments or curved lines in general is not allowed by the technology, each curve is replaced by a combination of straight line segments in a way to approximate the curve. This can be achieved with any number of straight line segments and combination of angles. The best results are obtained however when the maximum angles allowed by technology are used and the smallest number of straight line segments.

Two consecutive petals are connected at the same layer using curved segments 57, 61, 65, 73, 77, 81. The selection of the shape of these segments itself is not crucial for the invention but some shapes contribute to the increase of the performance of the inductor. Acute angles, however, should be avoided in general, as they exhibit higher resistance and introduce negative mutual coupling compared to the obtuse angles. Although a circular arc is a good choice, due to design constrictions of the specific process. The shape shown in Figure 4, which approximates the circular arc by consecutive line segments connected to an obtuse angle is proposed.

Hence, for example, for the typical technologies where the allowed angles between two segments are 0, 45°, 90° and 135°, the best combination for approximating any circular segment is two equal line segments forming an 135° angle.

Since the magnetic field of the inductor is strongest at its center, most designs propose the area around its center to be free of metal. Thus, in the proposed invention, a region centered on the center of the margarita-shaped inductor and with radius equal to about 1/3 of the radius of the virtual envelope circle of the inductor is left free of any metal. It is understood that any other value may be chosen, yet less than the radius of the outer circle.

Figure 4 shows that said embodiment with 4 loops is suitably represented by a clover shape wherein the aforementioned petals of the shape proposed according to the invention actually form the leaves of the clover like shape.

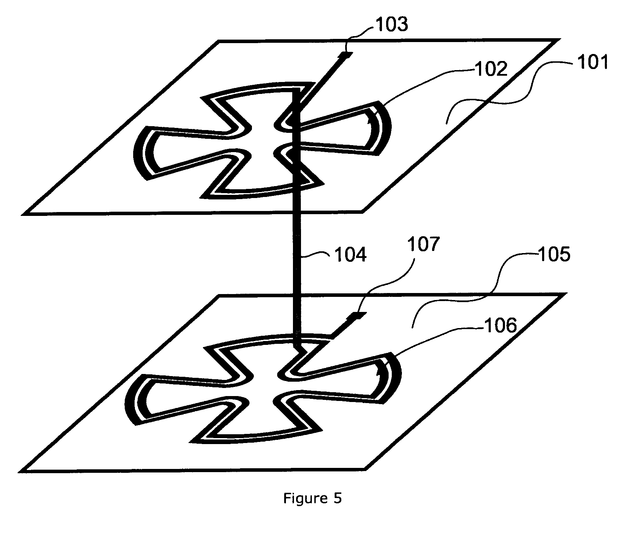

A margarita, resp. clover-shaped inductor according to this invention may consist of several layers, as it is the case for the traditional inductors. The design can be either simple or alternative. In the simple design, each layer is designed in a different metal layer and two consecutive layers are connected each other using vias. Each layer may have a different number of turns and/or petals, resp. leaves from the others, but for better results the number of turns and petals or leaves of each layer need to be equal. Referring to Figure 5, the second turn 102 of one layer 101, is connected to the second turn 106 of another layer 105 using vias 104, while the ports 103 and 107 of the inductor are located at these two different layers, respectively.

The alternative way for designing a multi-layer margarita-shaped inductor is shown in Figure 6. Here, the petals residing in the same layer are not all continuously connected as it was the case in Figure 5. Instead, some petals of one layer are connected in series with some petals of another layer. With reference to Figure 6, an inductor is shown, with the ports 116 and 117, and from which each petal of layer 113 is connected in series with another petal of layer 114. Since the petals which are being connected reside on different layers, vias 115 are used. Thus, for example referring to Figure 6, the petal 111 is connected in series with petal 112. Two consecutive connected petals need not necessarily to be along the same perpendicular line and any desired combination of connections among the petals may be made. The disadvantage of this type of connection is that the complexity of design is increased to some extent, but on the other hand the characteristics of the integrated margarita-shaped inductor including quality factor and operating frequency are further enhanced because currents with the same frequency are created in each perpendicular line.

In Figures 7-10, two pairs of LQ versus frequency figures are given, clearly showing the superiority of the margarita-shaped inductor compared to traditional ones not having said innovative shape. The comparison is performed for all cases between two inductors occupying equal surface areas. Specifically, in Figures 7 and 8 the inductance and quality factor of two inductors versus frequency are shown respectively. The dotted line corresponds to a two-layer single-turn traditional inductor while the continuous line to a two-layer single-turn 4 petals margarita-shaped inductor, according to this invention, which occupies equal area on the chip with the traditional inductor, showing the significant improvement that exhibits compared to the traditional inductor which occupies equal area on the chip with the traditional inductor, showing the superior performance compared to the traditional inductor.

A margarita-shaped inductor, according to this invention, can be combined with traditional coils, namely to be connected in series or parallel, if desired.

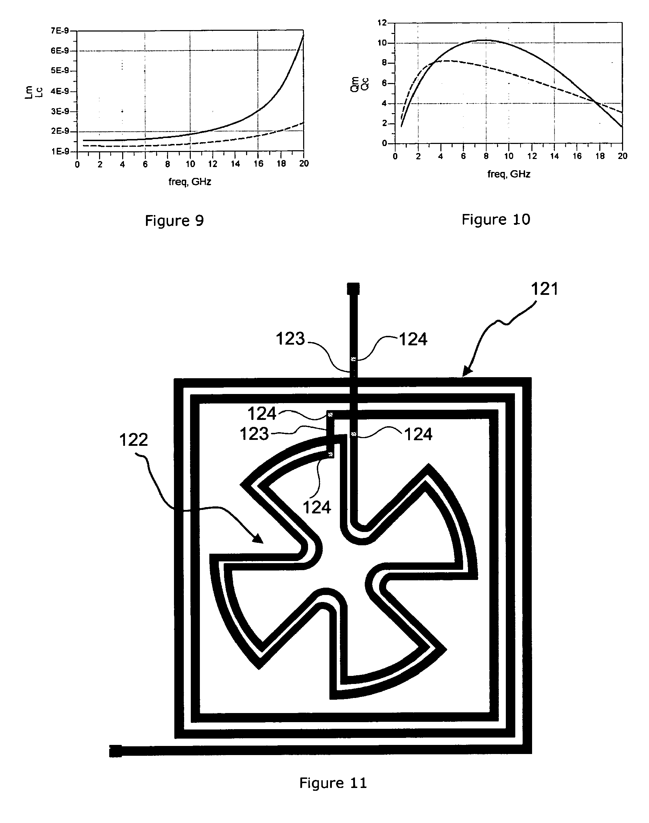

With reference to Figure 11, a traditional square inductor of 2,5 turns and one layer 121 is connected in series with a margarita-shaped inductor 122 of two turns and one layer, according to this invention. It is obvious that the number of turns and/or layers of the traditional inductor may differ from those of the margarita-shaped inductor, according to this invention. The last layer of the traditional inductor is connected with the last layer of the margarita-shaped inductor. If these layers overlap without any short-circuit the connection may be made directly, otherwise, i.e. if the last layer of the traditional inductor does not coincide with the last layer of the margarita-shaped inductor or the direct connection will result to a short-circuit, the different layers are connected together using vias 124 and underpass 123.

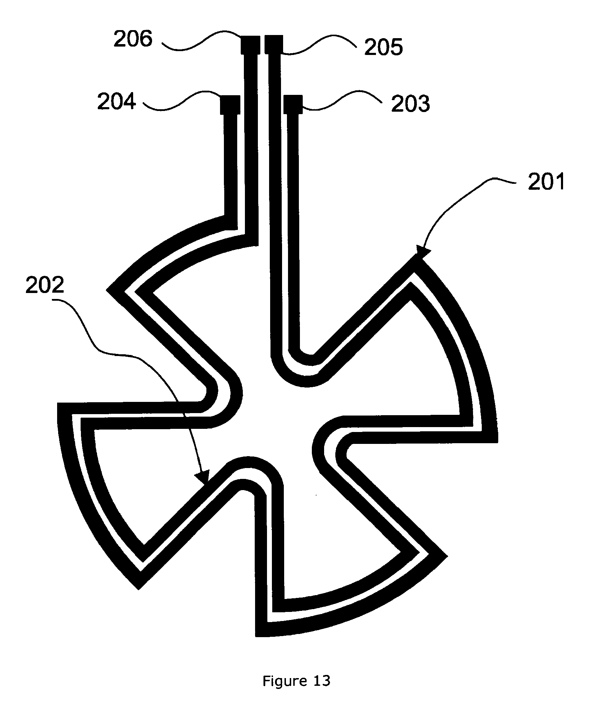

Two integrated margarita-shaped inductors, according to this invention, can be connected to a transformer configuration in one or more layers as it is the case for the traditional inductors. One margarita-shaped inductor is defined as the primary inductor of the transformer and the other as the secondary. This selection can be made arbitrarily. The primary or secondary inductor may consist of more than one margarita-shaped inductor connected in series. The design of the transformer is made in such a way that the magnetic field of the primary inductor couples with that of the secondary, to obtain the transformer. This can be achieved by either stacking the inductors at different layers, or by designing the turns of the primary and secondary inductors in such a way that each one encloses another or finally by a combination of these two ways. This way is described by means of an example with reference to Figures 12 and 13 for each case respectively.

Specifically, Figure 12 shows the connection of two margarita-shaped inductors of one layer and two turns, according to this invention, in a transformer configuration, designing the two inductors at different layers 151 and 161. Referring to Figure 12, the margarita-shaped inductors 152 and 162 are defined as the primary and the secondary inductors of the transformer, respectively. The ports of the primary and the secondary inductors are the 153, 154 and 163, 164 respectively. It is understood that the underpass used in each case should be designed at a different layer than those of the primary and secondary to avoid any short circuit due to underpass. This transformer design can be straightforwardly generalized for designs of more than two layers. Figure 13 shows a transformer configuration using one layer. The transformer consists of two margarita-shaped inductors of one turn and one layer, according to this invention. The turns of the margarita-shaped inductors 201 and 202 are designed in such a way that one encloses another as shown in the Figure. If 201 and 202 are defined as the primary and the secondary respectively, the ports of the primary will be 203 and 204 while the ones of the secondary will be 205 and 206. In the case of more than one turns, where an underpass is required, the same discussed earlier regarding the case of the transformer configuration in two layers, applies here as well.

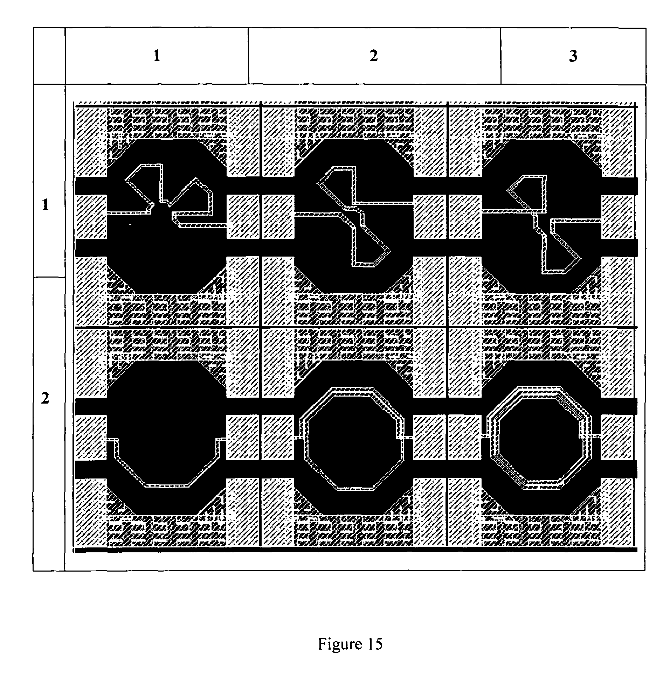

In Figure 15 part of the layout of the test chip fabricated for testing the margarita shaped inductor is shown. At the second row typical octagonal inductors are depicted while at the first row three margarita shaped inductors of two petals connected in different ways are shown.

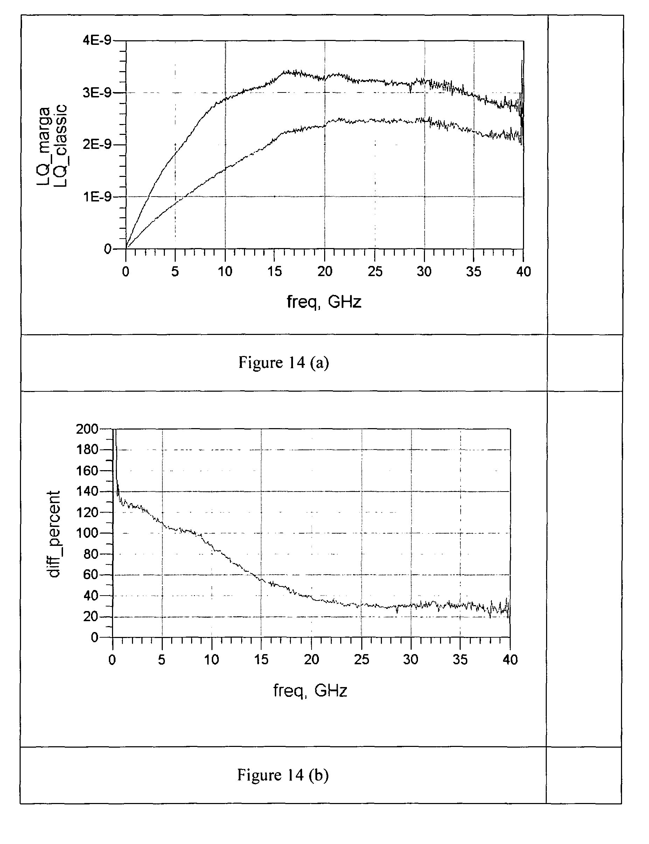

In Figures 14a and b a comparison between the measurement results of the 0,5 turn octagonal inductor (2^{nd} row - 1^{st} column) and the margarita shaped inductor of two petals (1^{st} row - 2^{nd} column) is presented. Specifically, in Figure 14a the product inductance times quality factor (L*Q) as a function of frequency for both inductors is depicted, while in Figure 14b their relative difference is presented. As it can be seen, the margarita shaped inductor outperforms the octagonal one.
It is further to be understood that the scope of the invention further includes all embodiments which may be defined as an inductor, in particular of the integrated or printed type, comprising a plurality of open loops with a predetermined shape connected in series along a virtual path around a virtual geometrical centre, each loop having two ends with their respective open side located between both said ends, thereby facing said fictive centre, **characterized in that** said open loops are mutually connected at their said ends belonging two adjacent loops, thereby facing said centre, wherein each said loop is mutually rotated over an angle α respective the adjacent loop around geometrical centre.

The abovementioned best embodiment with maximum 4 loops is suitably symbolized by a clover shape wherein the aforementioned petals of the shape proposed according to the invention actually form the leaves of the clover like shape. In other words, the shape as proposed according to the invention may equally be designated by a clover like shape in the embodiment with maximum 4 loops, (including 3) which constitutes an alternative representation of the inductor specifically shaped according to the invention.

## Claims

1. An inductor, in particular of the integrated or printed type, comprising a plurality of open loops with a predetermined shape connected in series along a virtual path around a geometrical centre, each loop having two ends with their respective open side located between both said ends, thereby facing said fictive centre, **characterized in that** said open loops are mutually connected at their said ends belonging to two adjacent loops, thereby facing said centre, wherein each said loop is mutually rotated over an angle respective the adjacent loop around geometrical centre.

2. An integrated or printed inductor, in particular according to claim 1, **characterized in that** it has a margarita shape comprising: open loops, a set of petals (54)-(55) (56), (58)-(59)-(60), (62)-(63)-(64), (66)-(67)-(68); (70)-(71)-(72), (74)-(75)-(76), (78)-(79)-(80), (82)-(83), wherein the petals are connected in series along a virtual path to form the inductor turns (52)-(67), (68)-(83) and each petal is turned to an angle to each preceding petal and the open part of the petals faces the centre of the inductor.

3. The inductor according to claim 1 or 2, **characterized in that** the number of petals is equal or greater than two, in particular equal or smaller than 4, more particularly wherein all said loops have a virtually identical shape.

4. The inductor according to one of the preceding claims, **characterized in that** in said margarita like shape, said open loops delimitate the margarita petals' perimeter, in particular composed of at least three parts, a peripheral one extending outwardly and two adjacent parts extending radially therefrom to said virtual centre.

5. The inductor according to one of the preceding claims, **characterized in that** each said open loop has a substantially curved like shape pointing at said virtual centre, in particular with an elongated profile, at least slightly, wherein said junction portions have an inwardly curved profile facing said centre.

6. The inductor according to claim 5, **characterized in that** each curve is replaced by a combination of straight line segments so as to approximate the curve, in particular with maximum angles and smallest number of straight line segments.

7. The inductor according to claim 2, **characterized in that** the shape of the petal is composed by two substantially equal radially extending line segments, the rays, forming an acute angle and a circular segment (55) connecting two opposite ends of theirs, in particular wherein each said open loop has an approximately substantially trapezoidal like shape pointing at said virtual centre, in particular with an elongated profile, at least slightly, wherein said junction portions have inwardly curved profile facing said centre.

8. The inductor according to one of the preceding claims, **characterized in that** it has a generally symmetrical overall shape with respect to said centre and/or **in that** said loops are arranged substantially in a plane.

9. The inductor according to one of the claims 1 to 5, **characterized in that** it comprises more than one layer (103), (106) in simple designing, wherein the petals of each layer are connected in series and layers are connected each other using vias, in particular wherein the number of turns and petals of each layer are equal.

10. The inductor according to one of the claims 1 to 5, **characterized in that** it comprises more than one layer (113, 114) in alternative designing, in particular wherein one petal of any layer is connected to any other petal of a different layer.

11. The inductor according to one of the preceding claims, **characterized in that** it further comprises conventional inductors connected together in series, in parallel or in combination thereof.

12. The inductor according to one of the claims 1 to 11, **characterized in that** it is connected as a transformer (201) and (202), (152) and (162).

13. Method of manufacturing an inductor according to one of the preceding claims, **characterized in that** the shaped inductor is fabricated in any typical process following the rules of each process.

14. Method of manufacturing, in particular according to claim 14, an inductor according to one of the claims 1 to 13, **characterized in that** the shaped inductor is fabricated to any metal layer and any type of metal offered by the process.

15. Use of the inductor as defined in one of the claims 1 to 12, **characterized in that** said inductor is incorporated in a complete circuit such as an LNA or a GPS receiver or a transceiver.
